# EUROPEAN PATENT SPECIFICATION

(11) **EP 3 039 948 B1**
(45) Date of publication and mention of the grant of the patent: **05.10.2022**
(21) Application number: 14840174.8
(22) Date of filing: 28.08.2014
(51) Int. Cl.: H05K 1/03, H05K 1/11, H05K 3/46, H05K 1/02, B41J 15/00

(54) **METHOD FOR MANUFACTURING A FLEXIBLE CIRCUIT BOARD**
VERFAHREN ZUR HERSTELLUNG EINER FLEXIBLEN LEITERPLATTE
PROCÉDÉ DE FABRICATION DE CARTE DE CIRCUITS IMPRIMÉS SOUPLE

(30) Priority: 30.08.2013 FI 20135878
(43) Date of publication of application: 06.07.2016
(73) Proprietor: Elcoflex OY, 90440 Kempele (FI)
(72) Inventor: TARVAINEN, Timo, FI-90440 Kempele (FI); PAAVOLA, Juho, FI-90440 Kempele (FI); PELTONIEMI, Timo, FI-90440 Kempele (FI)
(74) Representative: Berggren Oy
(86) International application number: PCT/FI2014/050654
(87) International publication number: WO 2015/028716

(56) References cited:
- EP-A2- 1 002 638
- EP-A2- 1 194 021
- GB-A- 2 458 986
- JP-A- H06 132 630
- US-A- 4 869 767
- US-A- 6 080 668
- US-A1- 2002 079 288
- US-A1- 2003 207 211
- US-A1- 2004 048 047
- US-A1- 2006 240 364
- US-A1- 2009 007 421
- US-A1- 2009 188 702

## Description

The invention relates to a method for manufacturing a flexible circuit board.

### Prior art

The two- or more-layered flexible circuit boards are usually manufactured by almost the same methods as the usual rigid circuit boards. The usual circuit boards have a base, a so-called substrate, which functions both as a mechanical support material and as an insulating material. In flexible circuit board structures, either a polyimide-based film (PI) or a polyester-based film (PET) or a polyether sulfone film (PES) is generally utilized as a flexible substrate. The polyimide film withstands temperatures over 300 °C. Kapton^{®}, Apical^{®} and Upilex^{®} are representatives of polyimide brands. The polyester-based films withstand temperatures of about 100 °C. Mylar^{®} and Melinex^{®} are examples of polyester-based brands.

Either a reel-to-reel manufacturing method or a panel process can be utilized in the manufacture of flexible circuit boards. In a reel-to-reel manufacturing method the film-like circuit board material is handled as long ribbons rolled to coils. The different manufacturing stages of the circuit board occur in the manufacturing equipment on the straight section arranged between the starting roll and the receiving roll. There can be many successive manufacturing stages. The reel-to-reel technique is well suited to be used when the manufacturing batches are large. Rigid circuit boards are generally manufactured with the panel process.

The publications US2006/0240364 and US 2003/0059578 disclose manufacturing methods, in which a clean metal film is used as one starting material in the reel-to-reel manufacturing method. The film is coated with an insulant, which is patterned. In both publications the metal film functions as a mechanical support element in the finished product.

The desired circuitry pattern on the surface of the circuit board can be manufactured for example by growing or etching. In the growing method, the desired circuitry pattern is formed electrolytically on the thin metal layer on the substrate. The original thin metal layer remained around the conductors after the growing stage is etched away.

A more conventional way to manufacture a conductor layer on the circuit board substrate is to use an etching method, in which the excessive metal on the surface of the circuit board substrate is removed by a chemical etching process. Thus, a metal foil covering the entire surface is laminated at least on the second surface of the circuit board substrate. The metal foil can be for example a copper laminate. If the circuit board concerned is a two-sided circuit board, an electrical connection between the copper laminates located on different sides of the circuit board substrate can be created through the vias.

The electrical connection between the conductive metal films located on the different sides of the circuit board substrate can be made for example by drilling first vias to the desired places. In the second manufacturing stage, copper is grown to the drilled via holes in a chemical process. The described manufacturing method is relatively expensive.

Another manufacturing method of the vias utilizes laser. In the first manufacturing stage a circuitry is prepared on both sides of the circuit board substrate. After this, a pit is made with laser through the conductor of the second side of the substrate, which pit extends also through the circuit board substrate nonetheless without penetrating the circuitry pattern on the second side. In the next manufacturing stage the pit is filled by pressing for example a conductive silver paste therein. This manufacturing method is more unreliable, since the hole made with laser can be indefinite and thus it's sufficiently good filling is uncertain.

Also so-called printed electronics can be utilized in the manufacturing of electric circuit complexes. In this manufacturing method the printing plate or the ink material in the printing plate contacts and adheres to the material functioning as a print carrier. An electrically insulating material, on which the desired circuit complexes are manufactured by printing, is used as a printing carrier. Electrically functional, fluid or powdery materials are available for manufacturing of both electrically conductive, insulating, semiconductive or optical circuit elements. If a two-sided circuit board is manufactured with this technique, the necessary vias must be prepared with the techniques described above.

US 2009/0007421 disclose a method for manufacturing flexible printed circuit board. A metal foil is supplied from a first feeding roller. The metal foil has a first surface and a second surface on two opposite sides of the metal foil. A first coverlay having a number of first openings defined therein is supplied from a second feeding roller and laminated on the first surface of the metal foil. Electrical traces are formed with the metal foil. A second coverlay having a number of second openings defined therein is supplied from a third feeding roller and laminated on the second surface of the metal foil. Each of the second openings registers with the respective first opening so that the electrical traces are exposed from the corresponding first and second openings.

US 666080668 depicts a method for manufacturing electronic circuit assemblies. A layer of dielectric material is attached to a layer of electrically conductive material. Vias are formed in the layer of dielectric material and filled with conductive paste material. The resulting assembly is attached to a substrate.

JP H06 132630 discloses a flexible circuit board and its manufacturing method. The structure comprises the following layers and details. At first, resin film 7 is placed onto metal foil 6. Via holes 8 are made into resin film 7. Conductive metal layer 9 is placed onto the whole holed structure. Material 10 is set in "pieces" (i.e. with gap locations) to both sides of the previously defined structure. Metals 6 and 9 "melt away" from the gaps of material 10, and also material 10 is then taken off. Photo etching can be used there. The end result is a flexible circuit board structure. Material 10 has been defined as anti-etching resist layer, and merely that.

### Objects of the invention

The object of the invention is to disclose at least a manufacturing method for a two-sided flexible circuit board, by which manufacturing method a flexible circuit board comprising electrical circuit elements can be cost-effectively manufactured with the reel-to-reel manufacturing equipment. The electrical vias of the two-sided flexible circuit board are implemented in connection with the patterning of the insulating, semiconductor and conductor materials.

The objects of the invention are obtained by a manufacturing method, in which the first patterned insulation layer, to which holes are left in the places of the vias, is pressed, printed or grown on a clean metal film, such as a copper film, having no support film. The first insulation layer can also be manufactured by laminating the insulation film patterned by punching to the metal foil. One or more conductive, semiconductive or insulating material layers can be printed in the following stages on the patterned insulation layer, so that the desired circuit complex can be manufactured. The vias of the circuit board according to the invention are implemented by pressing conductive material to the holes patterned to the first insulation layer, whereby they form an electrical contact through the insulation layer to the copper laminate. When all the material layers to be preferably printing technologically manufactured have been manufactured, the patterned side of the circuit board according to the invention is preferably attached to an appropriate support film. After this, the copper conductors of the circuit board are preferably patterned by etching to the second untreated surface of the metal foil. After etching, at least a patterned insulating protective layer can be printed on the copper conductors.

The advantage of the method according to the invention is that the vias of the at least two-layered, flexible circuit board can be reliably manufactured in connection with the circuitries to be made by printing.

Furthermore, the advantage of the invention is that all process steps are reel-to-reel processes, whereby the turnaround time required by the manufacture of the circuit board is short in large volumes, whereby cost savings are achieved.

Further, the advantage of the invention is that by printing the circuit elements directly on the surface of the metal foil, in which case the plastic film supporting the conventional copper laminate can be left out, more cost savings can be achieved.

Furthermore, the advantage of the invention is that compared to other printing technological manufacturing methods, in the manufacturing method according to the invention the metal foil stays solid during its printing process, whereby the metal foil also functions as a support element for the printing. Consequently, shrinkages, which make it difficult to obtain a desired accuracy of manufacture, are avoided.

The manufacturing method of the flexible circuit board according to the invention, in which manufacturing method electrical circuit elements are manufactured with a reel-to-reel manufacturing equipment, by which a first patterned insulation layer (22) is added by pressing or printing (101) on a first surface of a metal foil (21) having no support film, from which metal foil conductors (21a) of one layer of the flexible circuit board (20) are manufactured, the manufacturing method further comprising that
- a first patterned layer (23) of conductive material is added (102) on the first patterned insulation layer (22) and to holes (221, 222) therein for obtaining a first wiring layer and vias (231, 232) of the circuit board (20),
- an insulating, mechanical support film (25) is glued, printed or laminated on the first patterned insulation layer (22) and the first patterned layer (23) of conductive material, and
- after attaching the support film (25), the metal conductors (21a) to be arranged on the second surface of the metal foil (21) are manufactured by etching.

Some advantageous embodiments of the invention are presented in the dependent claims.

The basic idea of the invention is the following: In the manufacturing method according to the invention, no separate working phases are needed for connecting the components of the two conductive layers of the at least two-layered circuit board in desired places to each other by the electrically conductive vias through the insulation layer. The vias are manufactured in connection with the printing of the insulating and conductive layers of the circuit board, which layers are appropriately patterned. In the manufacturing method according to the invention, the first patterned insulation layer is preferably printed on the first surface of the clean metal foil, which is preferably a copper foil. Holes are left to the insulation layer in places where the vias are to be manufactured. In the following stages, one or more conductive, semiconductive or insulating material layers can be printed on the patterned insulation layer, so that the desired circuit complex can be manufactured. The vias of the circuit board according to the invention are preferably implemented by pressing conductive material to the holes patterned in the first insulation layer. With the conductive material pressed to the holes an electrical contact is provided from the printed conductive layer to the metal foil. Several patterned insulating and conductive layers can be printed on top of each other. When all the material layers to be manufactured on the first surface of the circuit board have been printed, so after this the side manufactured by printing of the flexible circuit board according to the invention, is preferably attached to an appropriate support film. The support film can comprise holes, through which an electrical connection can be made either to the metal foil or to the conductive layer. After this the copper conductors of the circuit board are preferably patterned by etching on the second yet untreated surface of the metal foil. After the etching of the conductors at least a patterned insulating protective layer can be printed on the manufactured metal conductors of the circuit board for getting the circuit board ready for operation.

In the following, the invention will be described in detail. In the description, reference is made to the enclosed drawings, in which
- Figure 1: shows as an exemplary flow chart the main stages of the manufacturing method of a circuit board according to the invention
- Figures 2a-2h: show by the way of an example cross-sections of a circuit board according to different stages of Figure 1.

The embodiments in the following description are only given as examples and a person skilled in the art can carry out the basic idea of the invention also in some other way than what is described in the description. Even though it may be referred to an embodiment or embodiments in several places of the description, this does not mean that the reference would be directed to only one described embodiment or that the described characteristic would be usable only in one described embodiment. The individual characteristics of two or more embodiments may be combined and new embodiments of the invention may thus be provided.

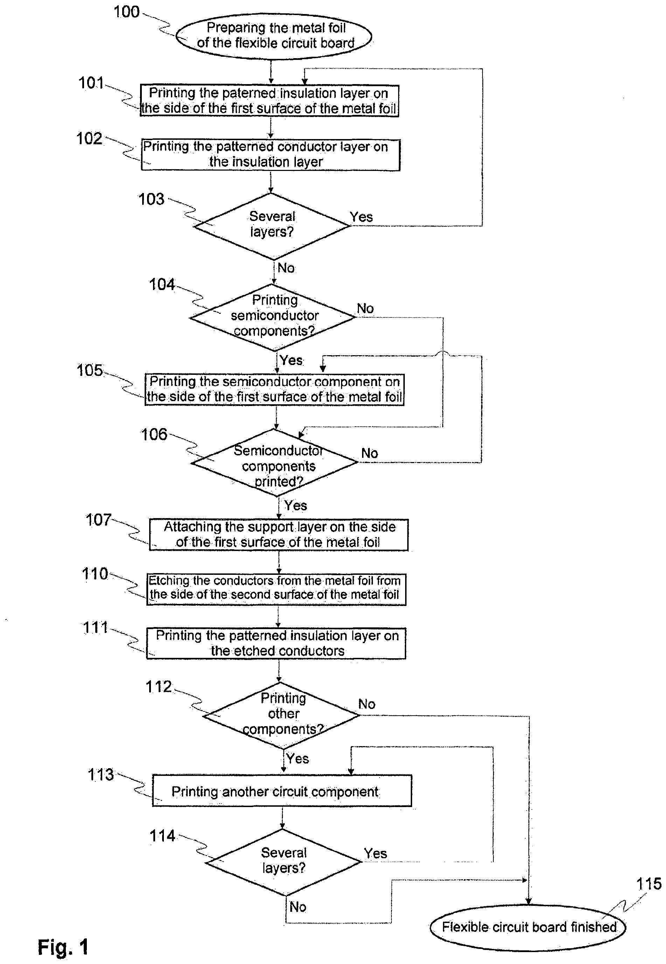

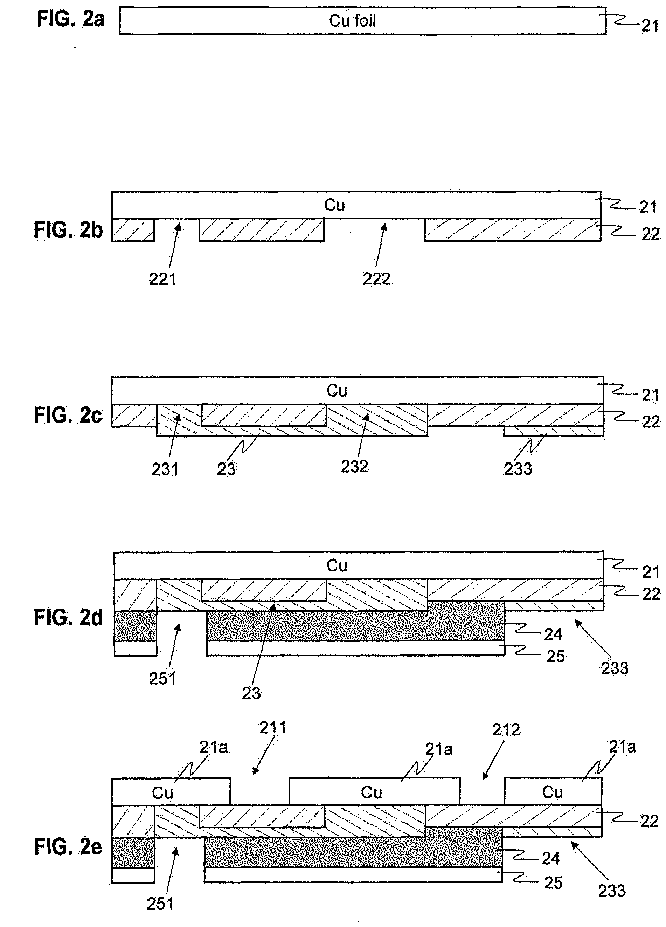

**Figure 1** shows as an exemplary flow chart the main stages of the manufacturing method of the flexible circuit board 20 according to the invention. For a person skilled in the art it is obvious that some of the stages shown in the flow chart of Figure 1 can also be implemented in some other order than what is shown in the exemplary flow chart of Figure 1. For example, stages 101, 102, 104, 105 and 106 of the flow chart of Figure 1 can be implemented in an order, in which stages 104, 105 and 106 precede stages 101 and 102. In connection with the description of the flow chart of Figure 1, the reference numerals shown in more detail in Figures 2a-2h are used as clarifying reference numerals.

Stage 100 precedes the actual manufacturing stages of the flexible circuit board 20. In stage 100, there is a ready-made clean metal foil 21, which is preferably a copper foil, aluminium foil or a nickel silver foil, to which no support film according to the prior art has been attached. In the following description, copper foil is used as an exemplary metal foil.

The order of magnitude of the thickness of the copper foil 21 of Figure 1 is preferably 18 µm. The copper coil 21 is packed to a coil, which can be used in a reel-to-reel printing machine. The copper foil 21 has two surfaces, which are in the following called as a first surface and as a second surface. In an exemplary structure of Figures 2a-2h the first surface can also be called as the lower surface of the copper foil 21 and the second surface as its upper surface.

In a preferred embodiment of the invention the clean copper foil 21 is coated in stage 100 from one side or both sides by a nickel-gold-layer having a chemical class of 4 µm. The manufacture of vias to be manufactured is enhanced by the coating treatment and the solderability of the contact points of the single components in the further processing is ensured.

In stage 101, the first patterned insulation layer 22 is pressed, printed or grown on the first surface (the lower surface in Figure 2b) of the copper foil 21, which insulation layer preferably comprises holes, through which the vias of the circuit board 20 can be implemented. The order of magnitude of the thickness of the insulation layer can preferably be 25 µm. The number, places, sizes and shapes of the holes 221 and 222 in the insulation layer can vary.

In another advantageous embodiment of the invention an insulation film, to which holes have been manufactured by punching, is laminated on the first surface of the copper foil 21 instead of printing the insulation layer.

In stage 102, a first patterned conductor layer 23, which can be for example silver paste or silver ink, is printed on the insulation layer 22. The order of magnitude of the thickness of the conductor layer 23 can preferably be 15 µm. At least a part of the circuitries between the electrical components to be integrated or mounted on the first side of the circuit board 20 can be preferably manufactured to the conductor layer 23. Also the vias (reference numerals 231 and 232 in Figure 2b) from the conductor layer 23 through the insulation layer 22 to the first surface of the copper foil 21 can be preferably manufactured simultaneously with the material of the conductor layer 23. Likewise, contact areas 233 for single components to be connected can be manufactured to the conductor layer 23.

After the printing of the first conductor layer 23, it is determined in the controlling stage 103, whether new insulation and/or conductor layers are printed on the manufactured conductor layer. If the conclusion is "Yes", it is returned to stage 101 in the manufacturing process, in which stage a new patterned insulation layer is printed. Also a new patterned conductor layer can be preferably printed on the printed insulation layer. This process loop 101-103 is repeated until the controlling stage 103 generates the conclusion "No", whereby the manufacturing process progresses to the controlling stage 104 of the manufacturing need of the semiconductor components. A multi-layered circuit board is obtainable by the described process by the manufacturing method according to the invention by repeating the process loop 101-103 at least twice.

Also semiconductor-based circuit components for a flexible circuit board 20 to be manufactured with the printing technique can be implemented by the manufacturing method of the flexible circuit board according to the invention. In stage 104 it is controlled, whether also semiconductor-based components are integrated to the circuit board 20 by pressing or printing. If the conclusion of the control of the controlling stage 104 is "No", it is moved directly to the next controlling stage 106 (the manufacturing stages of the semiconductor component are not included in the circuit board example shown in Figures 2a-2h).

If the conclusion of the control of the controlling stage 104 is "Yes", then one semiconductor component layer is manufactured in stage 105 by pressing or printing the semiconductor component material on the insulation and conductor layers manufactured on the first surface of the copper foil. The manufacturing of semiconductor components can comprise several individual successive pressing or printing times with different semiconductor material mixtures.

After each pressing or printing time of the semiconductor component it is controlled in the controlling stage 106, whether all the necessary semiconductor materials are manufactured or not. If the conclusion of the control is "No", it is returned to stage 105 and the next semiconductive material layer is manufactured.

The process loop 104-106 is repeated until the conclusion "Yes" is generated in stage 106. After this conclusion, the manufacturing process progresses to stage 107, in which a flexible, insulating support film 25 is attached on the circuit board elements manufactured on the first surface of the copper foil 21. The support film 25 is attached as a support element of the circuit board 20 for example by an adhesive layer 24 incorporated therein. The support film 25 protects the circuit elements of the circuit board 20 mechanically, electrically and chemically. After this, holes can be preferably made to the support film 25 for example for outer electrical connections.

As already mentioned above, the manufacturing stages 104-106 of the semiconductor components can precede the manufacturing stages 101-103 of the insulation layer 22 and the conductor layer 23. In this preferred embodiment the parts of the semiconductor component are pressed or printed directly on the first surface of the copper foil 21, which surface thus functions as a substrate. In this preferred embodiment the subsequent insulation and conductor layers are manufactured on the semiconductor layers.

When the support film 25 is attached on the first side of the circuit board 20 according to the invention, copper conductors 21a can be manufactured by etching on the yet solid second surface of the copper foil 21 in stage 110.

In stage 111, the copper conductors 21a are preferably protected by pressing or printing the insulation layer 26 on the etched copper conductors 21a. The insulation layer 26 can preferably be patterned, whereby it also comprises holes 261 and 262.

In the controlling stage 112 it is determined, whether other material layers are manufactured on the insulation layer that can be for example a conductive layer 27 or one or more semiconductive material layers.

If the conclusion of the controlling stage 112 is "No", the manufacturing process ends to stage 115, in which the flexible circuit board 20 is ready for the installation of the single components.

If the conclusion of the controlling stage 112 is "Yes", then the manufacturing process progresses to stage 113, in which one material layer is manufactured. After this in stage 114 it is controlled, whether still other material layers are manufactured or not.

If the conclusion of the controlling stage 114 is "Yes", the manufacturing process returns to stage 113, in which a new material layer is pressed or printed. This process loop 113-114 is repeated until the conclusion of the controlling stage 114 is "No", whereby the manufacturing process progresses to stage 115, in which the flexible circuit board 20 has been finished for the installation of the single components.

**Figures 2a-2h** show an exemplary three-layered flexible circuit board 20. In Figures 2a-2h an exemplary copper foil is used as a metal foil of the circuit board 20. The method is, however, not limited to the two- or three-layered circuit board, but the circuit board can comprise even more layers. In this example, the exemplary finished circuit board 20 does not include semiconductor components implemented by pressing or printing.

**Figure 2a** shows a clean copper foil 21, to which no separate plastic film has been laminated as a support element. In the manufacturing process according to the invention the copper foil 21 functions in the initial stages of the process also as a support element required by the printing process, so there is no need for a separate plastic support element. The order of magnitude of the thickness of the copper foil 21 is preferably 18 µm. In a preferred embodiment of the invention at least the second surface of the copper foil 21 is chemically coated with a nickel-gold-layer (not shown in Figure 2a). The order of magnitude of the thickness of the nickel-gold-layer is preferably 2-4 µm. The reliability of the vias to be manufactured, especially vias having a small diameter, and the contact points of the single components is enhanced with the coating treatment.

**Figure 2b** shows a patterned first insulation layer 22 pressed or printed on the first surface (lower surface) of the copper foil 21. The insulation layer 22 can also be a plastic film patterned by punching, which plastic film is laminated so as to engage to the first surface of the copper foil 21. The insulation layer 22 preferably comprises holes, the exemplary holes 221 and 222, through which the vias in the finished circuit board 20 from one conductive layer to another layer can be implemented. The order of magnitude of the thickness of the insulation layer 22 is preferably 25 µm. The number, places, sizes and shapes of the holes in the insulation layer can vary.

**Figure 2c** shows a first patterned conductor layer 23 pressed or printed on the insulation layer 22, which conductor layer can be for example silver paste or silver ink. The order of magnitude of the thickness of the insulation layer 23 is preferably 15 µm. At least a part of the circuitries between the electrical components to be integrated or mounted on the first side of the circuit board 20 are preferably in the conductor layer 23. The conductor layer 23 also comprises the vias 231 and 232 going from the conductor layer 23 through the insulation layer 22 and extending to the first surface of the copper foil 21. In the example of Figure 2c also the exemplary contact areas 233 for the single components to be connected to the circuit board 20 are shown in the conductor layer 23.

It is obvious for a person skilled in the art that a new unpatterned insulation layer or a patterned insulation layer and further thereon a conductive layer can be pressed or printed on the conductor layer 23 for manufacturing a multi-layered circuit board. **Figure 2d** shows a circuit board 20 as a semi-manufactured product, in which a flexible, insulating support film 25 is attached on the circuit board elements manufactured on the first surface of the copper foil 21. The support film 25 is preferably attached as a support element of the circuit board 20 for example by an adhesive layer 24 incorporated therein. The support film 25 can be for example a PET-film having a thickness of 25 µm, which PET-film is glued with a 50 µm thick hot-melt adhesive on the material layers manufactured on the first surface of the circuit board 20. The attached support film 25 protects the circuit elements of the circuit board 20 mechanically, electrically and chemically. Holes 251, for example for outer electrical connections, can be preferably made to the support film 25.

The attached support film 25 functions as a support element of the circuit board 20 in the etching and in the following manufacturing stages, since the copper foil, which earlier functioned as a supporting element in the etching has lost the main part of its copper.

A circuit board 20 is shown in **Figure 2e** after the etching stage. The parts of the copper foil remained on the circuit board after the etching are shown with reference numeral 21a. In the example of Figure 2e the copper foil has been removed from places 211 and 212 by etching. The parts of the copper foil remained after the etching, the three exemplary reference numerals 21a, can be for example circuitries between the components to be integrated or mounted on the circuit board 20. After the etching a part of the remained copper 21a can also be a ground plane needed by a circuit complex.

The pattern of layer 21 can preferably form through vias 211 and 212 the electrical connections of the active components pressed or printed also on the second side of the circuit board.

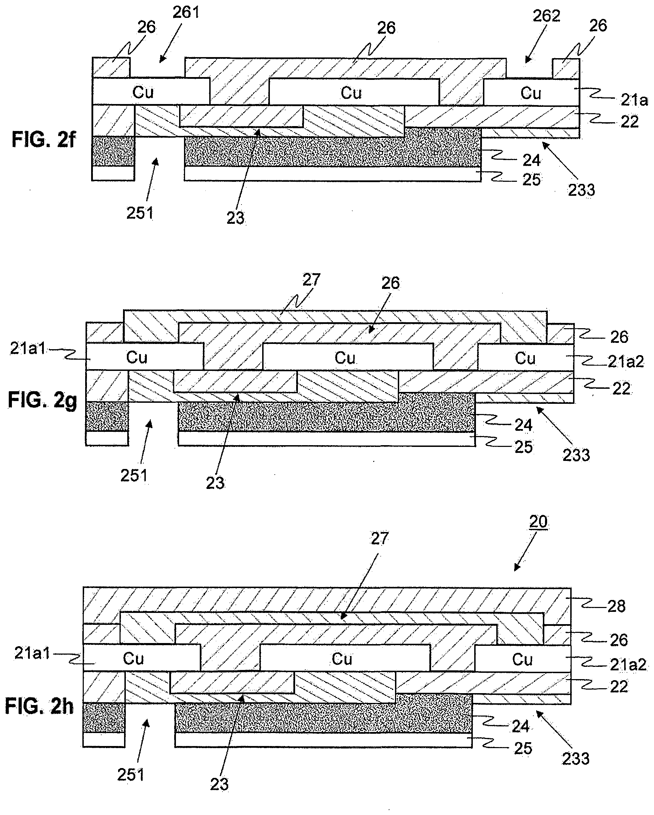

**Figure 2f** shows a circuit board 20 after the insulation layer 26 has been pressed or printed on the circuitry 21a on the second surface of the circuit board 20. The insulation layer 26 can also preferably be patterned, whereby it comprises holes, reference numerals 261 and 262.

**Figure 2g** shows a circuit board 20 after the patterned conductive layer 27 has been pressed of printed on the insulation layer 26. The conductive material of the conductive layer 27 fills the holes 261 and 262 in the insulating layer 26 all the way to the second surface (the upper surface in Figure 2g) of the etched conductors 21a. In the exemplary circuit board 20 of Figure 2g a circuitry is provided between the copper conductor 21a1 on the extreme left and the copper conductor 21a2 on the extreme right.

**Figure 2h** shows a circuit board 20 after the insulation layer 28 has been pressed or printed on the conductive layer 27. In the example of Figure 2h there are no holes in the insulating layer 28.

In another preferred embodiment of the invention the insulating layer has holes. Through holes single components can be connected to the circuit board.

In a preferred embodiment a new conductive layer can be manufactured on the patterned insulation layer 28, whereby the number of layers of the circuit board is increased by one. And if needed, a new insulating layer can be manufactured on this conductive layer.

In the above-described manufacturing method according to the invention a multi-layered flexible circuit board can be manufactured with the reel-to-reel technique on a clean copper foil. The problems appearing in connection with the electrical vias to be mechanically manufactured to the copper laminate of the prior art can be avoided by the manufacturing method according to the invention. Circuit boards for different RFID-circuit applications (Radio Frequency IDentification) can be cost-effectively manufactured by the manufacturing method according to the invention.

Some advantageous embodiments of the manufacturing method according to the invention and of the flexible circuit board obtained by the manufacturing method have been described above. The invention is not limited to the solutions described above, but the inventive idea can be applied in numerous ways within the scope of the claims.

## Claims

1. A manufacturing method of a flexible circuit board (20), in which manufacturing method electrical circuit elements are manufactured with a reel-to-reel manufacturing equipment, by which a first patterned insulation layer (22) is added by pressing or printing (101) on a first surface of a metal foil (21) having no support film, from which metal foil conductors (21a) of one layer of the flexible circuit board (20) are manufactured, the manufacturing method further comprising that
- a first patterned layer (23) of conductive material is added (102) on the first patterned insulation layer (22) and to holes (221, 222) therein for obtaining a first wiring layer and vias (231, 232) of the circuit board (20),
- an insulating, mechanical support film (25) is glued, printed or laminated on the first patterned insulation layer (22) and the first patterned layer (23) of conductive material, and
- after attaching the support film (25), the metal conductors (21a) to be arranged on the second surface of the metal foil (21) are manufactured by etching.

2. The manufacturing method according to claim 1, **characterised in that** a second patterned layer of insulating material is added on the first patterned conductive material layer (23) and on top of it further a second conductive layer for manufacturing a multi-layered circuit board.

3. The manufacturing method according to claim 1, **characterised in that** at least one patterned layer of first semi-conductive or second semi-conductive material is added either on the first surface of the metal foil (21), on the conductive layer (23) or insulating layer (22) on the metal foil for manufacturing at least one active circuit element.

4. The manufacturing method according to claim 2 or 3, **characterised in that** an insulating, mechanical support film (25) is glued, printed or laminated on added electrical circuit elements.

5. The manufacturing method according to claim 1, **characterised in that** either an unpatterned or a patterned insulation layer (26) is added on the metal conductors (21a) etched on the second surface of the metal foil (21).

6. The manufacturing method according to any of the claims 1-5, **characterised in that** a foil including copper, aluminium, or nickel silver is used as a metal foil (21).

## Patentansprüche

1. Herstellungsverfahren einer flexiblen Leiterplatte (20), wobei bei dem Herstellungsverfahren elektrische Schaltungselemente mit einer Rolle-zu-Rolle-Herstellungsanlage hergestellt werden, durch die eine erste strukturierte Isolationsschicht (22) durch Pressen oder Drucken (101) auf einer ersten Oberfläche einer Metallfolie (21) ohne Trägerfolie hinzugefügt wird, aus der Metallfolienleiter (21a) einer Schicht der flexiblen Leiterplatte (20) hergestellt werden, wobei das Herstellungsverfahren ferner umfasst, dass
- eine erste strukturierte Schicht (23) aus leitfähigem Material auf der ersten strukturierten Isolierschicht (22) und Löchern (221, 222) darin zum Erhalten einer ersten Verdrahtungsschicht und Durchkontaktierungen (231, 232) der Leiterplatte (20) hinzugefügt (102) wird,
- eine isolierende, mechanische Trägerfolie (25) auf die erste gemusterte Isolierschicht (22) und die erste gemusterte Schicht (23) aus leitfähigem Material geklebt, gedruckt oder laminiert wird, und
- nach dem Anbringen der Trägerfolie (25) die auf der zweiten Oberfläche der Metallfolie (21) anzuordnenden Metallleiter (21a) durch Ätzen hergestellt werden.

2. Herstellungsverfahren nach Anspruch 1, **dadurch gekennzeichnet, dass** eine zweite gemusterte Schicht aus isolierendem Material auf der ersten gemusterten leitenden Materialschicht (23) und darüber eine weitere zweite leitende Schicht zum Herstellen einer mehrschichtigen Leiterplatte hinzugefügt wird.

3. Herstellungsverfahren nach Anspruch 1, **dadurch gekennzeichnet, dass** mindestens eine strukturierte Schicht aus erstem halbleitendem oder zweitem halbleitendem Material entweder auf die erste Oberfläche der Metallfolie (21), auf die leitfähige Schicht (23) oder Isolierschicht (22) auf der Metallfolie zum Herstellen mindestens eines aktiven Schaltungselements hinzugefügt wird.

4. Herstellungsverfahren nach Anspruch 2 oder 3, **dadurch gekennzeichnet, dass** auf hinzugefügte elektrische Schaltungselemente eine isolierende, mechanische Trägerfolie (25) aufgeklebt, aufgedruckt oder auflaminiert wird.

5. Herstellungsverfahren nach Anspruch 1, **dadurch gekennzeichnet, dass** entweder eine ungemusterte oder eine gemusterte Isolationsschicht (26) auf den auf der zweiten Oberfläche der Metallfolie (21) geätzten Metallleitern (21a) hinzugefügt wird.

6. Herstellungsverfahren nach einem der Ansprüche 1 bis 5, **dadurch gekennzeichnet, dass** als Metallfolie (21) eine Folie aus Kupfer, Aluminium oder Neusilber verwendet wird.

## Revendications

1. Procédé de fabrication d'une carte de circuit imprimé flexible (20), dans lequel des éléments de circuit électrique de procédé de fabrication sont fabriqués avec un équipement de fabrication de bobine à bobine, par lequel une première couche d'isolation à motifs (22) est ajoutée par pressage ou impression (101) sur une première surface d'une feuille métallique (21) n'ayant pas de film de support, à partir de laquelle des conducteurs en feuille métallique (21a) d'une couche de la carte de circuit imprimé flexible (20) sont fabriqués, le procédé de fabrication comprenant en outre
- une première couche à motifs (23) de matériau conducteur est ajoutée (102) sur la première couche d'isolation à motifs (22) et aux trous (221, 222) à l'intérieur pour obtenir une première couche de câblage et des trous d'interconnexion (231, 232) de la carte de circuit imprimé (20),
- un film de support mécanique isolant (25) est collé, imprimé ou laminé sur la première couche d'isolation à motifs (22) et la première couche à motifs (23) de matériau conducteur, et
- après fixation du film de support (25), les conducteurs métalliques (21a) à agencer sur la seconde surface de la feuille métallique (21) sont fabriqués par gravure.

2. Procédé de fabrication selon la revendication 1, **caractérisé en ce qu'**une seconde couche à motifs de matériau isolant est ajoutée sur la première couche de matériau conducteur à motifs (23) et au-dessus de celle-ci en outre une seconde couche conductrice pour fabriquer une carte de circuit imprimé multicouche.

3. Procédé de fabrication selon la revendication 1, **caractérisé en ce qu'**au moins une couche à motifs de premier matériau semi-conducteur ou second matériau semi-conducteur est ajoutée soit sur la première surface de la feuille métallique (21), sur la couche conductrice (23) ou la couche d'isolation (22) sur la feuille métallique pour fabriquer au moins un élément de circuit actif.

4. Procédé de fabrication selon la revendication 2 ou 3, **caractérisé en ce qu'**un film de support mécanique isolant (25) est collé, imprimé ou laminé sur des éléments de circuit électrique ajoutés.

5. Procédé de fabrication selon la revendication 1, **caractérisé en ce qu'**une couche d'isolation sans motifs ou à motifs (26) est ajoutée sur les conducteurs métalliques (21a) gravés sur la seconde surface de la feuille métallique (21).

6. Procédé de fabrication selon l'une quelconque des revendications 1 à 5, **caractérisé en ce qu'**une feuille comportant du cuivre, de l'aluminium ou du maillechort est utilisée comme feuille métallique (21).
